# FASCICULE DE BREVET EUROPEEN

(11) **EP 2 296 180 B1**
(45) Date de publication et mention de la délivrance du brevet: **07.08.2013**
(21) Numéro de dépôt: 10354040.7
(22) Date de dépôt: 30.08.2010
(51) Int. Cl.: H01L 29/786, H01L 29/423, B82Y 10/00, H01L 29/06

(54) **Procédé de stabilisation de nanofils en germanium obtenus par condensation**
Verfahren zur Stabilisation von Nanodrähten aus Germanium erhalten durch Kondensation
Process of stabilisation of germanium nanowires obtained by condensation

(30) Priorité: 10.09.2009 FR 0904321
(43) Date de publication de la demande: 16.03.2011
(73) Titulaire: Commissariat à l'Énergie Atomique et aux Énergies Alternatives, 75015 Paris (FR)
(72) Inventeur: Saracco, Emeline, 38000 Grenoble (FR); Damlencourt, Jean-François, 38190 Laval (FR); Poiroux, Thierry, 38500 Voiron (FR)
(74) Mandataire: de Jong, Jean Jacques

(56) Documents cités:
- WO-A1-2008/069765
- WO-A1-2009/072984
- SARACCO ET AL.: "Fabrication of Suspended GE-rich Nanowires by Ge Enrichment Technique for Multi-channel Devices", ECS TRANSACTIONS, vol. 19, no. 1, mai 2009 (2009-05), pages 207-212, XP008121932,

## Description

### Domaine technique de l'invention

L'invention est relative à un procédé de formation d'au moins un nanofil suspendu en matériau monocristallin à base de germanium, procédé comportant successivement :
- la fourniture d'un substrat comportant, une première couche en silicium recouverte par une couche cible en matériau à base d'alliage de silicium-germanium,
- la formation d'au moins une poutre suspendue dans la couche cible,
- l'oxydation thermique de la poutre suspendue de manière à former, à la place de la poutre suspendue, ledit nanofil par condensation des atomes de germanium.

### État de la technique

L'amélioration continue des performances des circuits microélectroniques passe par une augmentation de la densité d'intégration des composants élémentaires des circuits. Jusqu'à présent, l'amélioration des performances a été réalisée par la miniaturisation continue des dimensions du transistor MOSFET. Les transistors sont maintenant de taille nanométrique et leur réalisation se heurte à de nombreuses difficultés technologiques. Les effets quantiques au sein du transistor à effet de champ ne sont plus négligeables et les matériaux classiques de la microélectronique ne sont plus aptes à fournir des caractéristiques en adéquation avec les spécifications demandées. Des solutions alternatives sont donc proposées afin de continuer à améliorer les performances des circuits microélectroniques.

Une des voies les plus prometteuses consiste à utiliser des nano-objets et plus précisément des nanofils semi-conducteurs. Les nanofils peuvent être utilisés pour former des canaux monocristallins de transistors de type MOS à effet de champ.

L'article de Saracco et al., « Fabrication of suspended Ge-rich nanowires by Ge condensation technique for multi-channel devices » ECS transaction, Vol. 19, May 2009, pp. 207-212, San Francisco, décrit un procédé de réalisation de nanofils en matériau semi-conducteur. Ces nanofils riches en germanium sont réalisés à partir de la condensation d'un film en alliage de silicium-germanium qui est soumis à une oxydation thermique. Lors de cette oxydation thermique, les atomes de silicium interviennent dans la formation d'un oxyde de silicium et les atomes de germanium sont repoussés hors de l'oxyde. De cette manière, les atomes de germanium non consommés par la formation de l'oxyde de silicium viennent se condenser dans une couche de silicium-germanium riche en germanium voire en une couche de germanium pur.

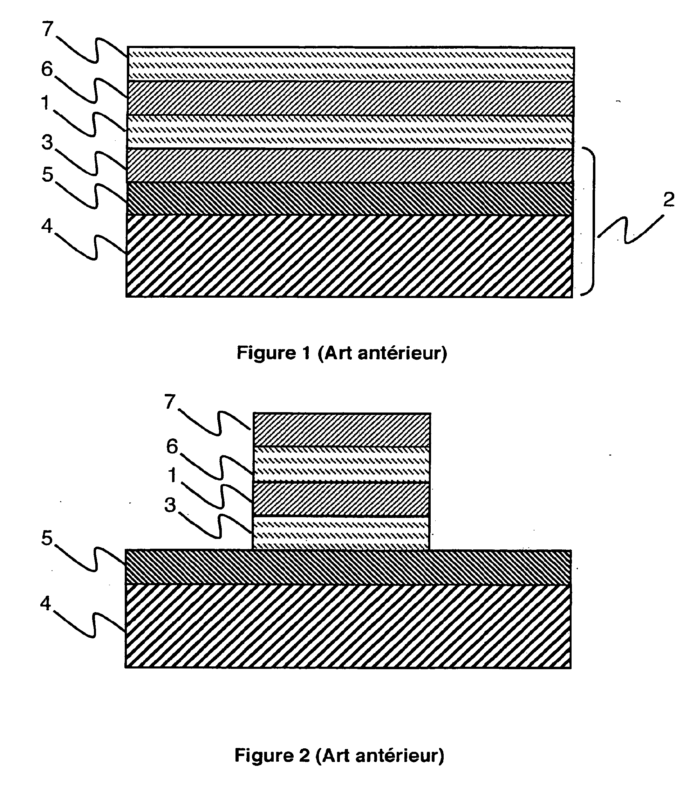

Dans ce mode de réalisation, illustré à la figure 1, une couche cible 1 en alliage de silicium-germanium est formée sur la surface en silicium d'un substrat 2 de type silicium sur isolant. Le substrat 2 comporte une première couche en silicium 3 qui est séparée du substrat de support 4 par un diélectrique enterré 5. La couche cible 1 en alliage de silicium-germanium est recouverte par une seconde couche en silicium 6 et une seconde couche cible 7 en alliage de silicium-germanium.

Comme illustré à la figure 2, les couches cibles en alliages de silicium-germanium 1 et 7 et les couches en silicium 3 et 6 sont gravées. Ensuite, comme illustré à la figure 3, les couches en silicium 3 et 6 sont éliminées de manière à ce que les couches en alliages de silicium-germanium forment des poutres suspendues au-dessus du substrat. Ces poutres suspendues 1 et 7 sont alors soumises à une oxydation thermique de manière à réaliser la condensation des atomes de germanium en des nanofils 8 riches en germanium (figure 4). A la fin du procédé d'oxydation thermique, les nanofils 8 sont entourés d'une couche d'oxyde de silicium 9.

Ce procédé de réalisation présente de nombreux avantages, il permet notamment de réaliser, de manière simple, un ou plusieurs nanofils dans un matériau semi-conducteur. Cependant, il est rare d'observer des nanofils à base de germanium qui présentent les caractéristiques électriques attendues Il est également difficile d'obtenir des circuits présentant un aussi faible taux de circuits non fonctionnels comparé une technologie classique.

### Objet de I'invention

L'invention a pour objet un procédé qui réduit voire élimine les phénomènes de déformation des nanofils tout en conservant une réalisation de nanofils riches en germanium facile à mettre en oeuvre.

Le procédé selon l'invention est **caractérisé en ce que** la première couche en silicium est contrainte en tension selon un plan parallèle à la surface principale du substrat et/ou la couche cible comporte des atomes de carbone, de sorte que dans un plan parallèle à la surface principale du substrat le paramètre de maille du matériau constituant la couche cible est identique, après élimination de la première couche en silicium, au paramètre de maille de ladite première couche en silicium.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

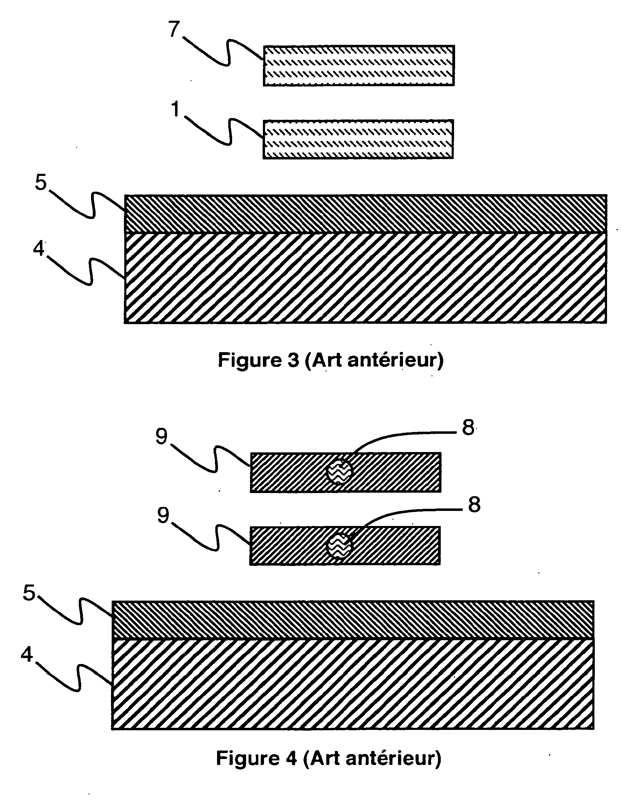

- les figures 1 à 4 représentent, de manière schématique, en coupe transversale, différentes étapes d'un procédé de réalisation, selon l'art antérieur,

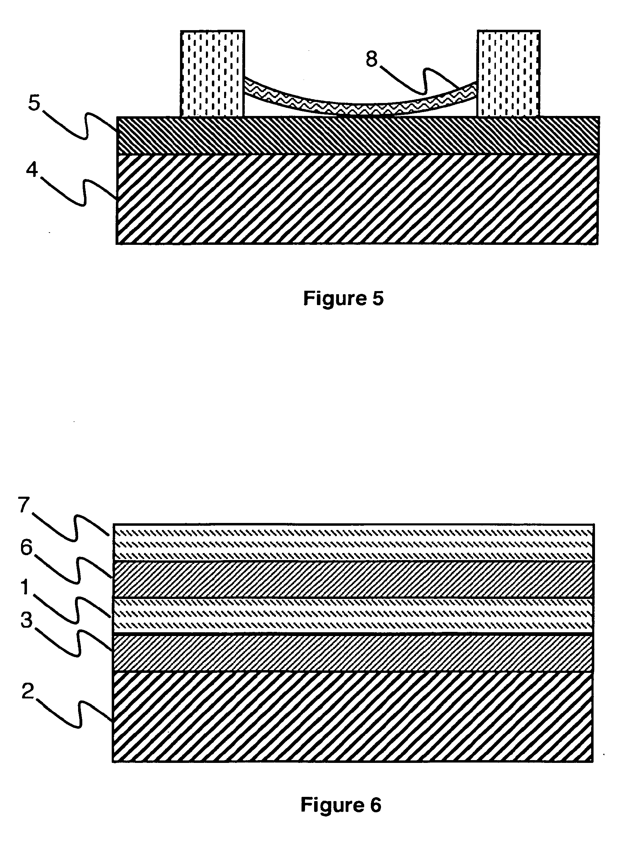

- la figure 5 représente, de manière schématique, en coupe, un nanofil déformé,
- les figures 6, 7, 9 et 10 représentent, de manière schématique, en coupe transversale, différentes étapes d'un procédé selon l'invention,

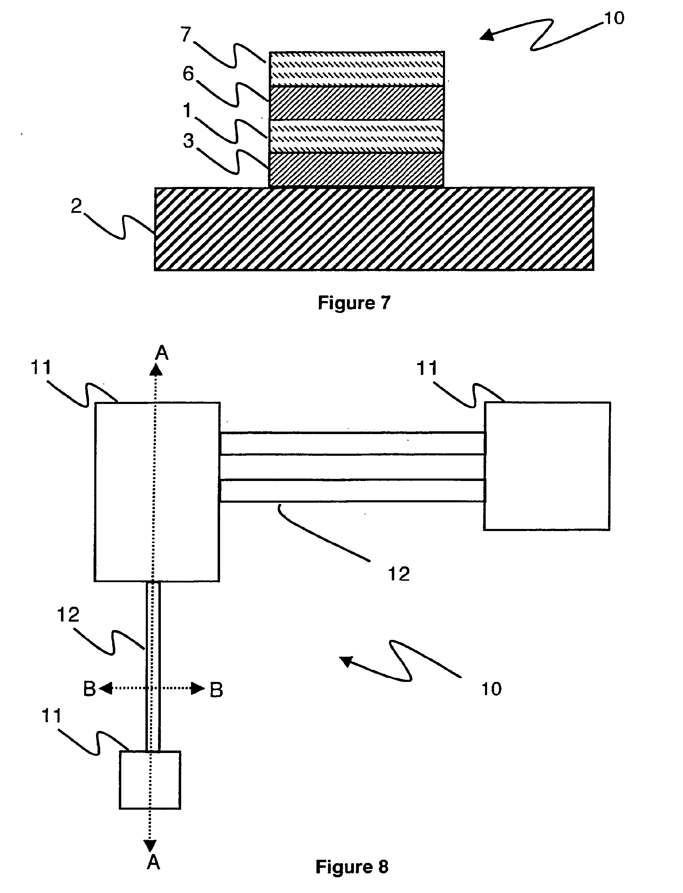

- la figure 8 représente, de manière schématique, en vue de dessus, un motif tridimensionnel correspondant à la figure 7, selon l'invention,

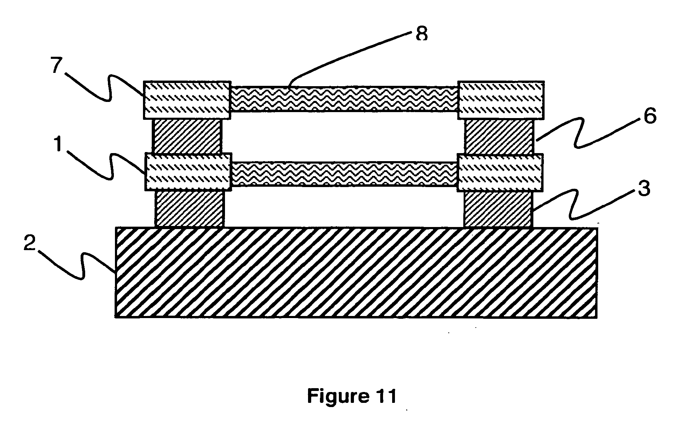

- la figure 11 représente, de manière schématique, en coupe longitudinale, des nanofils suspendus selon l'invention.

### Description d'un mode de réalisation préférentiel de l'invention

Comme illustré à la figure 5, il a été découvert que les nanofils à base de germanium réalisés, par exemple, selon le procédé de Saracco et al. cité plus haut, sont sujet à une déformation. De ce fait, les nanofils déformés peuvent être en contact avec d'autres nanofils et/ou d'autres éléments du substrat. Il a été également observé que lors de la formation des nanofils, les poutres suspendues sont également déformées ce qui peut également expliquer les difficultés d'obtention de circuits électroniques ayant des rendements aussi élevés que les circuits réalisés dans des technologies conventionnelles.

Une surface principale d'un substrat 2 est recouverte successivement par au moins une première couche en silicium 3 et une couche cible 1 à base d'alliage de silicium-germanium, la première couche en silicium 3 étant recouverte directement par la couche cible 1. Comme illustré à la figure 6, en variante, cet empilement peut être recouvert par au moins une couche additionnelle en silicium 6 et une couche cible additionnelle 7. Il est également possible de former une pluralité de couches cibles additionnelles et de couche additionnelles en silicium au-dessus de la première couche en silicium 3 et de la couche cible 1. Cependant, il est nécessaire qu'il y ait une alternance entre les couches cibles 1 et 7 et les couches en silicium 3 et 6. Chaque couche cible est en alliage de silicium-germanium, elle comporte donc au moins majoritairement des atomes de silicium et de germanium. La couche cible peut également comporter d'autres atomes tel que, par exemple, du bore, du phosphore, de l'arsenic ou du carbone. Les couches cibles 1 et 7 et les couches en silicium 3 et 6 sont monocristallines et en accord de maille avec la première couche en silicium 3.

Le substrat 2 peut être un substrat massif ou un substrat de type semi-conducteur sur isolant. La première couche en silicium 3 peut faire partie intégrante du substrat 2 ou alors être formée sur la surface principale du substrat 2. De ce fait, la première couche en silicium 3 peut être réalisée dans un matériau différent de celui constituant le substrat 2. Dans le cas d'un substrat de silicium sur isolant, la première couche en silicium 3 peut être directement disposée sur la couche en matériau diélectrique au dessus du substrat de support.

Le substrat 2 et les couches formées sont ensuite soumis à une série d'étapes technologiques afin de former au moins une poutre suspendue dans la couche cible 1, ici dans chaque couche cible 1 et 7. Cette poutre suspendue est reliée au substrat 2 par ses extrémités alors que sa partie centrale est libre.

Comme illustré à la figure 7, la première couche en silicium 3, la couche cible 1 en alliage de silicium-germanium et les couches additionnelles 6 et 7 sont structurées afin de permettre l'accès à la couche en silicium 3 de manière latérale. Avantageusement, le procédé de gravure est fortement anisotrope afin que le motif tridimensionnel présente des flancs verticaux. Cependant, un procédé de gravure qui présente également une composante isotrope de gravure pour le silicium seul n'est pas désavantageux.

La gravure des couches disposées à la surface du substrat 2 peut être réalisée par toute technique adaptée, par exemple, par photolithographie et gravure. Cette gravure peut également être réalisée au moyen d'un masque dur (non représenté) qui est préalablement structuré et qui va servir de modèle à la structuration des couches cibles 1 et 7 et des couches en silicium 3 et 6 sur la figure 7.

Comme illustré à la figure 8, dans un mode de réalisation avantageux, les couches présentes (1, 7, 3 et 6) sont structurées de manière à former un motif tridimensionnel. Le motif tridimensionnel 10 présente en vue de dessus ou selon un plan parallèle à la surface principale du substrat une forme particulière. Le motif tridimensionnel 10 comporte au moins deux zones de maintien 11 qui sont reliées entre elles par au moins une zone de liaison 12. Le motif tridimensionnel peut comporter une pluralité de zones de liaison 12 reliant une pluralité de zones de maintien 11 afin de former un circuit électronique. Il est possible que deux zones de maintien 11 soient reliées entre elles par plus d'une zone de liaison 12, par exemple deux zones de liaison 12 comme sur la figure 8. Il est également envisageable qu'une zone de maintien 11 soit reliée à plusieurs autres zones de maintien 11 au moyen d'une ou plusieurs zones de liaison (figure 8).

La zone de liaison 12 comporte une direction longitudinale et une direction transversale. Sur la figure 8, la direction longitudinale est représentée par la direction AA alors que la direction transversale est représentée par la direction BB. Les zones de maintien 11 sont disposées à chaque extrémité de la zone de liaison selon la direction longitudinale. Les zones de maintien 11 présentent également des directions longitudinale et transversale. Selon sa direction transversale, la zone de liaison 12 présente une dimension, la largeur, inférieure aux dimensions de la zone de maintien selon les directions longitudinale et transversale. Dans ce cas de figure, les zones de maintien 11 et la zone de liaison sont formés par les mêmes matériaux.

Ainsi, la largeur et la longueur de la zone de maintien 11 sont toujours supérieures à la largeur de la zone de liaison 12. Dans le cas où les dimensions transversales des zones de liaison ne sont pas constantes au sein d'une zone de liaison 12 et/ou entre différentes zones de liaison 12, il faut prendre en compte la largeur la plus importante présente sur la surface du substrat pour définir la dimension minimale (transversale et longitudinale) des zones de maintien 11.

Il est également possible de structurer les couches présentes pour ne former que la zone de liaison 12 et de former par la suite les zones de maintien 11. Ces zones de maintien peuvent être formée par exemple en matériau métallique ou dans des matériaux qui sont insensibles aux étapes technologiques à venir. Avantageusement, une fois la zone de liaison formée, les couches en silicium sont gravées sélectivement sur une fine épaisseur au moins dans les zones en contact avec les futures zones de maintien 11. De ce fait, lors de la formation de la zone de maintien 11, les extrémités des films en alliages de silicium-germanium sont noyées dans la zone de maintien.

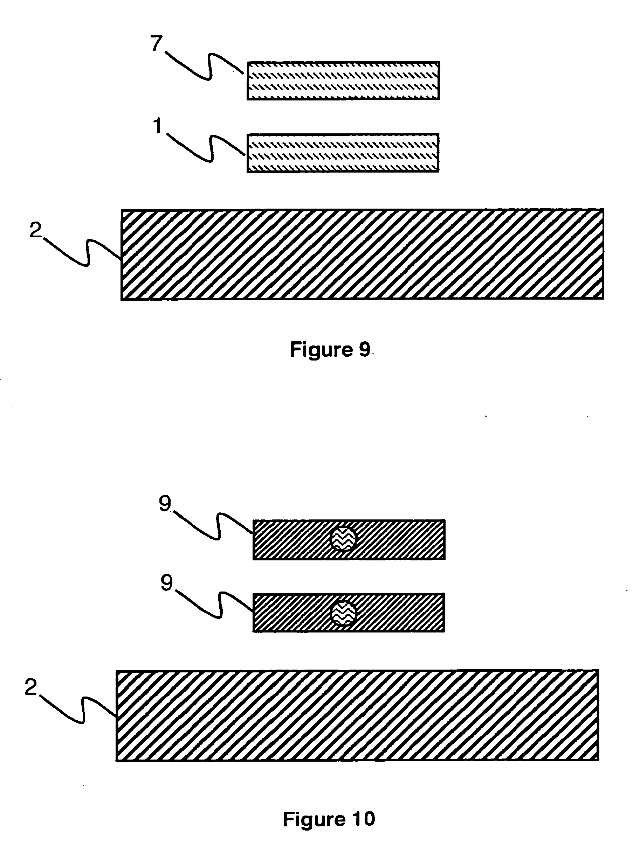

Comme illustré à la figure 9, dans une section d'une zone de liaison 12 selon la direction transversale BB, une fois le motif tridimensionnel 10 formé, les couches en silicium 3 et 6 sont éliminées dans les zones de liaison 12. Il en résulte que les couches cibles 1 et 7 forment des ponts suspendus au-dessus du substrat 2. Les ponts suspendus des couches cibles 1 et 7 sont maintenues au-dessus du substrat au moyen des zones de maintien 11 qui sont disposées de part et d'autre des ponts.

L'élimination des couches en silicium est réalisée au moyen d'une gravure sélective entre le silicium et les alliages de silicium-germanium présents. La gravure peut être réalisée au moyen d'une gravure par plasma, d'une gravure par acide chlorhydrique gazeux ou par voie humide. Cette gravure étant isotrope, il peut y avoir également attaque des couches de silicium présentes dans les zones de maintien 11. Les temps de gravure sont donc choisis pour assurer la libération des ponts tout en conservant l'intégrité des zones de maintien 11. La gravure des couches de silicium 3 et 6 dans les zones de liaison 12 est réalisée depuis les faces latérales de la zone de liaison. Les dimensions transversales et longitudinales des zones de maintien 11 sont également choisies pour assurer une certaine marge dans le procédé de gravure des couches en silicium de la zone de liaison 12 par rapport aux zones de maintien 11.

Suite à l'élimination des couches en silicium 3 et 6 dans la zone de liaison 12 pour former des ponts suspendus dans les couches cibles 1 et 7, il n'y a plus de contrainte exercée par le substrat 2 sur les ponts suspendus. Il en résulte alors que les matériaux des ponts suspendus peuvent relaxer les contraintes qu'ils détenaient ce qui se traduit généralement par une déformation des poutres, typiquement un flambage des poutres. Afin d'éviter ce phénomène de déformation, les caractéristiques de la première couche en silicium 3 et/ou des couches cibles 1 et 7 sont modifiées. Il est possible de modifier leur composition chimique et/ou leur procédé de réalisation. Dans la mesure où la couche cible 1 et la couche cible additionnelle 7 sont dans des alliages de silicium-germanium qui présentent un paramètre de maille à l'état relaxé plus grand que la paramètre de maille du silicium, il est nécessaire de trouver un moyen de faire correspondre ces paramètres de maille à celui imposé par le substrat, c'est-à-dire par la première couche en silicium 3.

De manière générale, pour éviter que la poutre suspendue ne se déforme par flambage, il faut que le paramètre de maille du matériau constituant la poutre présente à l'état relaxé le même paramètre de maille que la première couche en silicium 3. La distance entre les zones de maintien 11 étant constante, une augmentation du paramètre de maille de la poutre se traduit par une augmentation de la longueur de la poutre et donc sa déformation. Il faut donc que, dans un plan parallèle à la surface principale du substrat 2, le paramètre de maille de la première couche en silicium 3 soit identique au paramètre de maille du matériau constituant la poutre suspendue, après élimination de ladite première couche en silicium 3.

Dans un premier mode de réalisation, la première couche en silicium 3 est contrainte en tension selon un plan parallèle à la surface principale du substrat. Sous l'effet de cette contrainte, le paramètre de maille de la première couche en silicium 3, dans un plan parallèle à la surface principale du substrat, est plus grand que dans son état relaxé (non contraint). Le paramètre de maille est alors identique à celui d'un alliage de silicium-germanium particulier. De manière conventionnelle, il est possible de réaliser des films de silicium contraints en tension dont la contrainte permet l'obtention d'un film de silicium dont le paramètre de maille est équivalent à celui d'un alliage de silicium-germanium comportant jusqu'à 30% de germanium. Ces films sont communément appelés films de silicium contraints en tension à 30%. En adaptant la contrainte appliquée à la première couche en silicium 3 et la concentration en germanium des couches cibles 1, 7, il peut y avoir identité des paramètres de maille entre les différentes couches. Les paramètres de maille à l'état relaxé étant identiques dans le plan parallèle à la surface principale du substrat, il n'y a pas de champ de contraintes entre les deux matériaux, ce qui évite le phénomène de flambage par relaxation des contraintes.

Dans ce premier mode de réalisation, la première couche en silicium 3 peut provenir d'un substrat de type silicium contraint sur isolant ou être formée sur un substrat en germanium ou en silicium-germanium relaxé qui impose la déformation de la maille cristalline du silicium de la couche 3. Dans le cas d'un substrat de type silicium contraint sur isolant, la première couche en silicium 3 est directement disposée sur une couche de matériau diélectrique.

Dans un second mode de réalisation, des atomes de carbone sont incorporés au sein de la couche cible 1, 7 qui est alors en alliage de silicium-germanium-carbone. Alors que les atomes de germanium ont pour effet d'augmenter le paramètre de maille de l'alliage de silicium-germanium de manière sensiblement proportionnellement avec la concentration en atomes de germanium, les atomes de carbone ont un effet opposé sur le paramètre de maille. Ainsi, au fur et à mesure que la concentration en carbone augmente, le paramètre de maille de l'alliage silicium-germanium-carbone décroît, la concentration en germanium étant constante. De cette manière, en ajustant les concentrations en germanium et en carbone, il est possible d'obtenir un alliage de type SiGeC qui présente à l'état non contraint un paramètre de maille identique à celui du silicium. De manière conventionnelle, des concentrations maximales en carbone de l'ordre de 2% sont atteignables par épitaxie. Il est donc possible d'obtenir un alliage de type SiGeC contenant 20% de germanium, 2% de carbone et qui présente le même paramètre de maille que le silicium. Le carbone ayant un effet dix fois plus important que le germanium sur la paramètre de maille, les alliages de silicium-germanium-carbone comportent une concentration en germanium dix fois plus importante que la concentration en carbone afin d'avoir un paramètre de maille identique à celui du silicium non contraint.

Dans ce second mode de réalisation, la première couche en silicium 3 peut provenir d'un substrat de type silicium sur isolant ou alors être la partie supérieure d'un substrat massif en silicium. Avantageusement, l'intégration à partir d'un substrat de type silicium sur isolant est réalisée si l'on cherche à utiliser les nanofils pour former un circuit de type CMOS.

Si plus d'une couche cible est réalisée sur le substrat, par exemple une couche cible 1 et une couche cible additionnelle 7, il est possible que ces deux couches n'aient pas les mêmes concentrations en germanium et en carbone. Cependant, elles présentent le même paramètre de maille.

Ces deux modes de réalisation peuvent être combinés, ainsi il est possible d'intégrer, sur une première couche en silicium contraint, une couche cible en alliage de silicium-germanium-carbone. L'alliage de SiGeC peut contenir une quantité plus importante de germanium de sorte que la compensation du paramètre de maille réalisée par le carbone s'adapte au paramètre de maille de la première couche en silicium contrainte 3.

La modification apportée aux couches cibles 1, 7 et/ou à la première couche de silicium 3 permet de limiter voire d'annuler les champs de contraintes qui existent entre ces couches. Ainsi, dans la zone de liaison 12, dans un plan parallèle à la surface principale du substrat, il y a conservation du paramètre de maille de la couche cible 1 et de la couche cible additionnelle 7 avant et après élimination des couches en silicium 3 et 6. Ce paramètre de maille correspond à celui de la première couche en silicium 3.

Comme illustré à la figure 10, une fois les poutres suspendues formées dans les couches cibles 1 et 7, les poutres suspendues sont soumises à une oxydation thermique. Cette oxydation thermique va réaliser la condensation du germanium et former un nanofil 8 suspendu à base de germanium, c'est-à-dire un nanofil en germanium pur ou en alliage de silicium-germanium riche en germanium. Avantageusement, la concentration en germanium dans les couches cibles est de l'ordre de 30% et la concentration en germanium est comprise entre 50% et 80%. Le nanofil 8 à base de germanium présente alors une direction longitudinale identique à celle de la poutre suspendue 1, 7 à l'intérieure de laquelle il est formé. Le nanofil ainsi formé est donc dans un matériau semi-conducteur cristallin qui comporte essentiellement des atomes de germanium. Ainsi, lors de l'oxydation thermique, chaque poutre suspendue est remplacée par un nanofil 8 par condensation des atomes de germanium.

Lors de l'étape d'oxydation, il y a oxydation sélective des atomes de silicium pour former un oxyde de silicium. Les atomes de germanium ne participant pas à la formation de l'oxyde, ils ne sont pas incorporés dans l'oxyde de silicium et ils sont maintenus hors de l'oxyde de silicium. L'oxydation étant réalisée par apport d'atomes d'oxygène sur les surfaces latérales de la zones de liaison 12, les atomes de germanium sont repoussés vers l'intérieur de la couche cible 1, 7 au fur et à mesure de la progression de l'interface entre l'oxyde de silicium 9 et l'alliage de silicium-germanium. Lors de la condensation, il y a enrichissement continu de l'alliage de silicium-germanium en atomes de germanium et transformation d'un matériau semi-conducteur de forme parallélépipédique en un matériau semi-conducteur de forme cylindrique. Ainsi, la concentration en germanium du nanofil 8 est supérieure à la concentration en germanium dans la couche cible correspondante.

Lorsque la zone de liaison 12 comporte plusieurs couches cibles 1, 7, il y a formation d'un nanofil 8 par couche cible. Ainsi, comme illustré à la figure 10, les couches cibles 1 et 7 ont permis la formation de deux nanofils 8 distincts. La taille du nanofil 8, typiquement son diamètre, dépend des dimensions du pont suspendu initial, son épaisseur et sa largeur. Ainsi, si les couches cibles 1 et 7 présentent des épaisseurs différentes et une largeur identique, les nanofils qui en découleront auront des diamètres différents. Le diamètre du nanofil 8 dépend également de la durée et des conditions de l'étape d'oxydation thermique. Plus l'oxyde formé sera épais et plus le nanofil sera mince au regard des dimensions initiales de la poutre suspendue.

Dans le cas où les nanofils 8 sont en germanium pur, il est également possible de moduler l'épaisseur des nanofils 8 en ne modulant que la concentration en germanium entre les différentes couches cibles 1, 7 en alliage de silicium-germanium. Il est alors possible de moduler également la concentration en carbone pour conserver une identité du paramètre de maille.

Lors de l'étape d'oxydation thermique, il y a également oxydation des zones de maintien 11, il est donc nécessaire de prendre en compte ce paramètre afin d'éviter une trop grande consommation des zones de maintien par un oxyde de silicium.

Par ailleurs, l'utilisation de couches cibles 1, 7 en alliage de silicium-germanium-carbone n'est pas incompatible avec la réalisation de nanofils en germanium. En effet, il a été découvert que lors de l'oxydation d'un film en alliage de silicium-germanium-carbone, le carbone réagit avec l'oxygène et disparaît de l'alliage. Ainsi, le nanofil obtenu à partir d'un film de SiGeC complètement oxydé est un nanotube en germanium pur.

Avantageusement, les nanotubes à base d'alliage de silicium-germanium ne comprennent pas d'atomes de carbones car ces derniers forment des amas. Ces amas d'atomes de carbone peuvent être préjudiciables au transport des porteurs de charge. Dans ces conditions, la condensation du film en alliage de silicium-germanium est complète pour obtenir un nanotube sans carbone. Il est également possible de former un film en alliage de silicium-germanium seul pris en sandwich entre deux films en alliage de silicium-germanium-carbone. Il est alors avantageux que les trois films aient le même paramètre de maille, c'est-à-dire des concentrations en germanium différentes afin de tenir compte de l'incorporation de carbone dans les deux films externes du sandwich.

Il a été également découvert que, contrairement à ce qui était attendu, l'oxydation de la couche cible pour transformer la couche cible en un nanofil 8 ne se traduit pas par une déformation du nanofil. En effet, Lors de la condensation du germanium depuis la couche cible vers le nanofil il y a augmentation de la concentration en germanium et donc du paramètre de maille. Une déformation de la poutre et du futur nanofil est donc attendue lors de l'étape d'oxydation thermique, cependant, l'oxyde de silicium formé autour de la couche cible 1, 7 évite toute déformation. Ainsi, l'obtention d'une couche cible 1, 7 non déformée dans la zone de liaison se traduit après l'étape d'oxydation par un nanofil conservant un axe longitudinal parallèle à la surface principale du substrat.

Comme illustré à la figure 11, le procédé décrit ci-dessus permet d'obtenir des nanofils 8 parallèles à la surface du substrat 2. Ces nanofils sont maintenus en suspension au moyen des zones de maintien 11 et la distance verticale entre deux nanofils est définie par l'épaisseur du film en silicium 6 qui est compris entre les deux couches cibles 1 et 7 correspondantes.

## Revendications

1. Procédé de formation d'au moins un nanofil (8) suspendu en matériau monocristallin à base de germanium, procédé comportant successivement :
- la fourniture d'un substrat (2) comportant, une première couche en silicium (3) recouverte par une couche cible (1) en matériau à base d'alliage de silicium-germanlum,
- la formation d'au moins une poutre suspendue dans la couche cible (1),
- l'oxydation thermique de la poutre suspendue de manière à former, à la place de la poutre suspendue, ledit nanofil (8) par condensation des atomes de germanium,
procédé **caractérisé en ce que**, dans un plan parallèle à la surface principale du substrat (2), le paramètre de maille de la première couche en silicium (3) est identique au paramètre de maille du matériau constituant la poutre suspendue, après élimination de ladite première couche en silicium (3) et **en ce que** la couche cible (1) comporte des atomes de carbone.

2. Procédé selon la revendication 1, **caractérisé en ce que** dans la couche cible (1), la concentration en germanium est dix fois supérieure à la concentration en carbone.

3. Procédé selon l'une des revendications 1 et 2, **caractérisé en ce que** la première couche en silicium (3) est contrainte en tension selon un plan parallèle à la surface principale du substrat (2).

4. Procédé de formation d'au moins un nanofil (8) suspendu en matériau monocristallin à base de germanium, procédé comportant successivement :
- la fourniture d'un substrat (2) comportant, une première couche en silicium (3) recouverte par une couche cible (1) en matériau à base d'alliage de silicium-germanium,
- la formation d'au moins une poutre suspendue dans la couche cible (1),
- l'oxydation thermique de la poutre suspendue de manière à former, à la place de la poutre suspendue, ledit nanofil (8) par condensation des atomes de germanium,
procédé **caractérisé en ce que**, dans un plan parallèle à la surface principale du substrat (2), le paramètre de maille de la première couche en silicium (3) est identique au paramètre de maille du matériau constituant la poutre suspendue, après élimination de ladite première couche en silicium (3) et **en ce que** la première couche en silicium (3) est contrainte en tension selon un plan parallèle à la surface principale du substrat (2).

5. Procédé selon l'une quelconque des revendications 1 à 4, **caractérisé en ce que** le substrat (2) est un substrat de type silicium sur isolant, la première couche en silicium (3) étant disposée directement sur un matériau diélectrique.

6. Procédé selon l'une quelconque des revendications 1 à 5, **caractérisé en ce que** le substrat (2) comporte au moins une couche cible additionnelle (7) et une couche additionnelle en silicium (6), le substrat (2) comportant une alternance entre les couches cibles (1, 7) et lesdites couches en silicium (3, 6).

7. Procédé selon la revendication 6, **caractérisé en ce que** la couche cible (1) et la couche cible additionnelle (7) comportent des concentrations différentes en germanium et en carbone.

8. Procédé selon l'une quelconque des revendications 1 à 7, **caractérisé en ce que** la formation de la poutre suspendue est réalisée par la structuration des couches cible (1, 7) et en silicium (3, 6) pour former un motif tridimensionnel ayant, dans un plan parallèle à une surface principale du substrat (2), au moins deux zones de maintien (11) repliées entre elles par au moins une zone de liaison (12) et par l'élimination de la première couche en silicium (3) dans la zone de liaison.

9. Procédé selon la revendication 8, **caractérisé en ce que** le motif tridimensionnel (10) comporte une pluralité de zones de liaisons (12).

10. Procédé selon l'une des revendications 8 et 9, **caractérisé en ce que** la zone de liaison (12) présente, dans une direction transversale, une dimension inférieure à des dimensions longitudinale et transversale des zones de maintien (11), les zones de maintien (11) et de liaison étant constituées par les mêmes matériaux.

## Patentansprüche

1. Verfahren zur Bildung von mindestens einem in monokristallinem Material auf Germaniumbasis aufgehängten Nanodraht (8), wobei das Verfahren Folgendes umfasst:
- die Bereitstellung eines Substrats (2) mit einer ersten Siliziumschicht (3), die von einer Zielschicht (1) aus einem Material auf der Basis einer Silizium-Germanium-Legierung bedeckt ist,
- die Ausbildung mindestens eines Hängebalkens in der Zielschicht (1),
- die Wärmeoxidation des Hängebalkens derart, dass anstelle des Hängebalkens der Nanodraht (8) durch Kondensation der Germaniumatome gebildet wird,
**dadurch gekennzeichnet, dass** in einer Ebene parallel zur Hauptfläche des Substrats (2) der Maschenparameter der ersten Siliziumschicht (3) nach der Entfernung dieser ersten Siliziumschicht (3) identisch mit dem Maschenparameter des den Hängebalken bildenden Materials ist und dass die Zielschicht (1) Kohlenstoffatome aufweist.

2. Verfahren gemäß Anspruch 1, **dadurch gekennzeichnet, dass** in der Zielschicht (1) die Germaniumkonzentration das Zehnfache der Kohlenstoffkonzentration beträgt.

3. Verfahren gemäß einem der Ansprüche 1 und 2, **dadurch gekennzeichnet, dass** die erste Siliziumschicht (3) in einer Ebene parallel zu der Hauptfläche des Substrats (2) unter Zugspannung gesetzt wird.

4. Verfahren zur Bildung mindestens eines in monokristallinem Material auf Germaniumbasis aufgehängten Nanodrahtes (8), wobei das Verfahren Folgendes umfasst:
- die Bereitstellung eines Substrats (2) mit einer ersten Siliziumschicht (3), die von einer Zielschicht (1) aus einem Material auf der Basis einer Silizium-Germanium-Legierung bedeckt ist,
- die Ausbildung von mindestens einem Hängebalken in der Zielschicht (1),
- die Wärmeoxidation des Hängebalkens derart, dass anstelle des Hängebalkens der Nanodraht (8) durch Kondensation der Germaniumatome gebildet wird,
**dadurch gekennzeichnet, dass** in einer Ebene parallel zur Hauptfläche des Substrats (2) der Maschenparameter der ersten Siliziumschicht (3) nach der Entfernung dieser ersten Siliziumschicht (3) identisch mit dem Maschenparameter des den Hängebalken bildenden Materials ist und dass die erste Siliziumschicht (3) in einer Ebene parallel zur Hauptfläche des Substrats (2) unter Zugspannung gesetzt wird.

5. Verfahren gemäß einem der Ansprüche 1 bis 4, **dadurch gekennzeichnet, dass** das Substrat (2) ein Substrat vom Typ Silizium-auf-Isolator ist, wobei die erste Siliziumschicht (3) unmittelbar auf ein dielektrisches Material aufgebracht ist.

6. Verfahren gemäß einem der Ansprüche 1 bis 5, **dadurch gekennzeichnet, dass** das Substrat (2) mindestens eine zusätzliche Zielschicht (7) sowie eine zusätzliche Siliziumschicht (6) umfasst, wobei das Substrat (2) eine Wechselfolge zwischen den Zielschichten (1, 7) und den Siliziumschichten (3, 6) aufweist.

7. Verfahren gemäß Anspruch 6, **dadurch gekennzeichnet, dass** die Zielschicht (1) und die zusätzliche Zielschicht (7) unterschiedliche Germanium- und Kohlenstoffkonzentrationen aufweisen.

8. Verfahren gemäß einem der Ansprüche 1 bis 7, **dadurch gekennzeichnet, dass** die Bildung des Hängebalkens durch die Strukturierung der Zielschichten (1, 7) und Siliziumschichten (3, 6) realisiert wird, um ein dreidimensionales Muster herzustellen, das in einer Ebene parallel zu einer Hauptfläche des Substrats (2) mindestens zwei Stützbereiche (11) aufweist, die durch mindestens einen Verbindungsbereich (12) und durch die Entfernung der ersten Siliziumschicht (3) in dem Verbindungsbereich untereinander verbunden sind.

9. Verfahren gemäß Anspruch 8, **dadurch gekennzeichnet, dass** das dreidimensionale Muster (10) mehrere Verbindungsbereiche (12) aufweist.

10. Verfahren gemäß einem der Ansprüche 8 und 9, **dadurch gekennzeichnet, dass** der Verbindungsbereich (12) in einer Querrichtung eine geringere Abmessung gegenüber den Längs- und Querabmessungen der Stützbereiche (11) aufweist, wobei die Stütz- (11) und Verbindungsbereiche aus denselben Materialien bestehen.

## Claims

1. Method for forming at least one suspended nanowire (8) made from germanium-base single-crystal material, method successively comprising:
- providing a substrate (2) comprising a first silicon layer (3) covered by a target layer (1) made from a silicon-germanium alloy-base material,
- forming at least one suspended beam in the target layer (1),
- thermally oxidizing the suspended beam so as to form said nanowire (8), in the place of the suspended beam, by condensation of the germanium atoms,
method **characterized in that**, in a plane parallel to the main surface of the substrate (2), the lattice parameter of the first silicon layer (3) is identical to the lattice parameter of the material constituting the suspended beam, after said first silicon layer (3) has been eliminated, and **in that** the target layer (1) comprises carbon atoms.

2. Method according to claim 1, **characterized in that** the germanium concentration in the target layer (1) is ten times greater than the carbon concentration.

3. Method according to one of claims 1 and 2, **characterized in that** the first silicon layer (3) is tensile stressed in a plane parallel to the main surface of the substrate (2).

4. Method for forming at least one suspended nanowire (8) made from germanium-base single-crystal material, method successively comprising:
- providing a substrate (2) comprising a first silicon layer (3) covered by a target layer (1) made from a silicon-germanium alloy-base material,
- forming at least one suspended beam in the target layer (1),
- thermally oxidizing the suspended beam so as to form said nanowire (8), in the place of the suspended beam, by condensation of the germanium atoms,
method **characterized in that**, in a plane parallel to the main surface of the substrate (2), the lattice parameter of the first silicon layer (3) is identical to the lattice parameter of the material constituting the suspended beam, after said first silicon layer (3) has been eliminated, and **in that** the first silicon layer (3) is tensile stressed in a plane parallel to the main surface of the substrate (2).

5. Method according to any one of claims 1 to 4, **characterized in that** the substrate (2) is a silicon-on-insulator substrate, the first silicon layer (3) being arranged directly on a dielectric material.

6. Method according to any one of claims 1 to 5, **characterized in that** the substrate (2) comprises at least one additional target layer (7) and one additional silicon layer (6), the substrate (2) comprising an alternation between the target layers (1, 7) and said silicon layers (3, 6).

7. Method according to claim 6, **characterized in that** the target layer (1) and the additional target layer (7) comprise different germanium and carbon concentrations.

8. Method according to any one of claims 1 to 7, **characterized in that** forming the suspended beam is achieved by patterning the target layers (1, 7) and silicon layers (3, 6) to form a three-dimensional pattern having, in a plane parallel to a main surface of the substrate (2), at least two securing areas (11) connected to one another by at least one connecting area (12) and by eliminating the first silicon layer (3) in the connecting area.

9. Method according to claim 8, **characterized in that** the three-dimensional pattern (10) comprises a plurality of connecting areas (12).

10. Method according to one of claims 8 and 9, **characterized in that**, in a transverse direction, the connecting area (12) presents a smaller dimension than the longitudinal and transverse dimensions of the securing areas (11), the securing (11) and connecting areas being formed by the same materials.
